# EUROPEAN PATENT SPECIFICATION

(11) **EP 0 650 213 B1**
(45) Date of publication and mention of the grant of the patent: **01.08.2001**
(21) Application number: 94116641.5
(22) Date of filing: 21.10.1994
(51) Int. Cl.: H01Q 1/36, H01Q 1/24, H03D 9/06

(54) **Array antenna and production process therefor**
Gruppenantenne und deren Herstellungsverfahren
Réseau d'antennes et méthode pour sa fabrication

(30) Priority: 22.10.1993 JP 26494593
(43) Date of publication of application: 26.04.1995
(73) Proprietor: INTERNATIONAL SUPERCONDUCTIVITY TECHNOLOGY CENTER, Tokyo (JP); NEC CORPORATION, Tokyo (JP); E.I. DU PONT DE NEMOURS AND COMPANY, Wilmington Delaware 19898 (US)
(72) Inventor: Suzuki, Katsumi, c/o Superconductivity Res. Lab., 14-3, Shinonome 1-chome, Koto-ku, Tokyo (JP); Enomoto, Youichi c/o Superconductivity Res. Lab., 14-3, Shinonome 1-chome, Koto-ku, Tokyo (JP); Tanaka, Shoji, c/o Superconductivity Research Lab., 14-3, Shinonome 1-chome, Koto-ku, Tokyo (JP); Yamaguchi, Keiichi, c/o Superconductivity Res. Lab, 14-3, Shinonome, Koto-ku, Tokyo (JP); Murphy, Arthur T., Chadds Ford, PA 19317 (US)
(74) Representative: Glawe, Delfs, Moll & Partner

(56) References cited:
- DE-A- 3 613 258
- FR-A- 2 394 896
- GB-A- 2 223 130
- US-A- 4 777 490
- US-A- 5 105 200

## Description

The present invention relates to an array antenna including non-linear elements active at a temperature lower than or equal to liquid nitrogen temperature in respective unit elements and having a frequency transforming means (frequency mixing) arranged in a form of an array.

In seeking for application of superconductor in electronic devices, it is important to effectively utilize low conductivity of the superconductor. Even in the superconductor having zero direct current resistance or the superconductor which has lower resistance in comparison with normal conductor, a high frequency resistance is not always superior to the normal conductor. This is because that while the high frequency resistance of the superconductor is proportional to square of the frequency, the high frequency resistance of the normal conductor is proportional to 1/2 power of the frequency. In the high frequency range, especially at a frequency range higher than or equal to several tens GHz, a resistance of a superconductor transfer path becomes large to require some measure in circuit construction. (see Piel et al., "High Temperature Superconductors in High Frequency Fields-Fundamentals and Applications, Proceeding of the 4th International Symposium on Superconductivity, October, 1991, Tokyo, pp 925). In an example of a patch array antenna an electromagnetic wave received by antenna, a narrow but long signal transmission line (hereinafter referred to as feed line) is employed for transferring electromagnetic wave to a signal detecting portion in the case of the patch array antenna, in which patches serving as antenna elements of the patch array antenna are arranged. The total length of the portion of the feed line is inherently proportional to number of the patches provided in the array to increase resistance loss in the feed line portion. Therefore, the signal intensity at the signal detecting portion is not increased in proportion to the increased number of patch to lower effect of the array form arrangement of the patches. Therefore, there are a plurality of proposals for feeding the signal received by antenna to the signal detecting portion with maintaining sufficient signal intensity. In the proposals, it has been proposed to interpose a semiconductor amplifier at the intermediate position of the feed line or to form the feed line portion of a superconductor or an optical cable having lesser resistance.

For example, A. Balasubramaniyan, et al. "An Eight MOSFET periodic Spatial Power Combiner" 1993 IEEE MTT-S Digest, pp 811 proposes the feed line construction, in which eight semiconductor amplifiers are provided. On the other hand, in Lewis, et al. "Performance of TlCaBaCuO 30 GHz Element Antenna Array", IEEE Transaction on Applied Superconductivity, Vol. 3, March, 1993, pp 2844, employment of the superconductor in the feed line portion has been proposed. Also, Banerjee, et al. "An X-Band Phased Array Microwave/Photonic Beamforming Network", IEEE MTT-S Digest, pp 505 proposes employment of the optical cable in the feed line.

However, except for the superconductor, it is technically difficult or even impossible to form several tens or several hundreds of semiconductor amplifiers within an array antenna. On the other hand, as set forth above, at the high frequency range, such as microwave band, the resistance of the superconductor becomes substantially equal to or even higher than the normal conductor to make the benefit of employment of the superconductor in the feed line lost.

Further concrete discussion for the employment of the superconductor line proposed by Lewis et al. set forth above will be given herebelow.

On a 2 inches LaAlO₃ substrate, TlCaBaCuO oxide high temperature superconductor layer is formed and then, the patch portions and feed lines are patterned. On the back side surface of the substrate, a grounding surface of gold (Au) is formed. Sixty-four patches are arranged in 8 x 8 pattern with element spacing substantially one-half of the free space wavelength. Summing of power is made at equi-distance point on the feed lines of two patches. The summed power is again subject summing of the power in the feed line at equi-distance point from the power summing points. By repeating summing of the power for six times in total, all power received by all patches can be concentrated into one feed line. Assuming that the dimension of the individual patch is 1.35 mm x 0.9 mm, the performance of the patch array antenna becomes maximum at 31 GHz. However, in order to improve the performance in this frequency range, and for obtaining the patch array antenna covering higher frequency range, the loss in the superconductor has to be reduced.

US-A-5,105,200 discloses an antenna array according to the preamble of claim 1 wherein the antenna array comprises a superconductor directly connected to superconducting feed lines. Furthermore, the method for manufacturing such a superconducting antenna array comprising the deposition of superconducting films by for instance ion cluster beam method is disclosed.

GB-A-2,223,130 discloses a non-superconducting antenna array wherein each antenna patch is connected to a non-linear element.

It is an object of the invention to provide a device that makes it possible to get adavantage of the low resistance of superconducting materials in feed networks for patch antennas that are used at very high frequencies by converting the high frequency to a lower frequency immediately at the antenna.

A further object of the invention is to provide a technology which makes it possible to improve characteristics of a high density array antenna with taking capability of high density packaging of the superconducting feed line.

A further object is to provide a method for manufacturing such an antenna array.

These objects are achieved by an antenna array as defined in claim 1 and by a method as defined in claim 6, respectively.

The present invention will be understood more fully from the detailed description given herebelow and from the accompanying drawings of the preferred embodiment of the invention, which, however, should not be taken to be limitative to the present invention, but are for explanation and understanding only.

In the drawings:
Figs. 1A to 1D are sections showing respective steps in fabrication process of the preferred embodiment of an array antenna according to the present invention;
Fig. 2 is a plan view and a sectional view showing one example of a non-linear response portion of the superconductor in the preferred embodiment of the array antenna according to the invention;
Fig. 3 is a plan view showing one example of one unit portion of the preferred embodiment of the array antenna;
Fig. 4 is a plan view showing an example one unit consisted of four arrays in the preferred embodiment of the array antenna;
Fig. 5 is a diagrammatic and conceptual illustration showing one example of the case where measurement of the array antenna;
Fig. 6 is an illustration showing a frequency transformation characteristics and a bias voltage characteristics of the preferred embodiment of the array antenna; and
Fig. 7 is an illustration showing a conceptual construction of an application of a mixer array antenna, in which the present invention belongs.

The present invention will be discussed hereinafter in detail in terms of the preferred embodiments with reference to the accompanying drawings. In the following description, numerous specific details are set forth in order to provide a thorough understanding of the present invention. It will be obvious, however, to those skilled in the art that the present invention may be practiced without these specific details. In other instance, well-known structures are not shown in detail in order to unnecessary obscure the present invention.

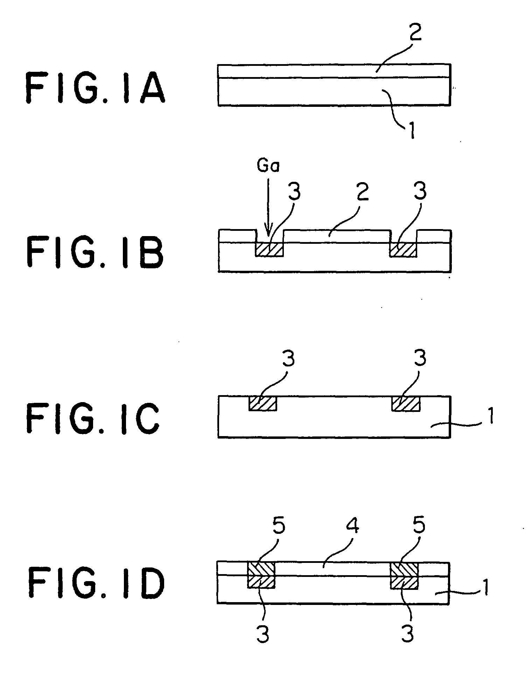

Figs. 1A to 1D are sections showing respective steps in fabrication process of the preferred embodiment of an array antenna according to the present invention.

In the fabrication process of the preferred embodiment of the array antenna, an Au film 2 in a thickness of approximately 100 nm is formed on the overall major surface of a MgO(100) substrate 1 by vacuum deposition method, as shown in Fig. 1A. Then, the substrate 1 is set within a focused ion beam device (FIB) to irradiate Ga⁺ ion beam accelerated at 30 KeV to positions forming junctions, as shown in Fig. 1B. The diameter of the irradiated ion beam is 50 nm. At this time, in order to form Ga irradiated regions (implanted layer) 3 on the MgO substrate 1, ion beam current is controlled in a range of 1 pA to 60 nA.

Subsequently, as shown in Fig. 1C, the Au film 2 is removed from the overall surface of the substrate 1. Various method may be employed for removing the Au film. However, the preferred method would be Ar⁺ ion milling at 450 eV or wet method with a solution of 2.6 wt% of KI and 0.65 wt% of I for lesser influence for the substrate.

Thereafter, as shown in Fig. 1D, YBaCuO (hereinafter referred to as "YBCO") film 4 is deposited by a pulse laser deposition in the thickness of 300 nm over the entire surface of the substrate. The YBCO film 4 on the irradiated region 3 becomes modified region which serves as a normal conductor region 5.

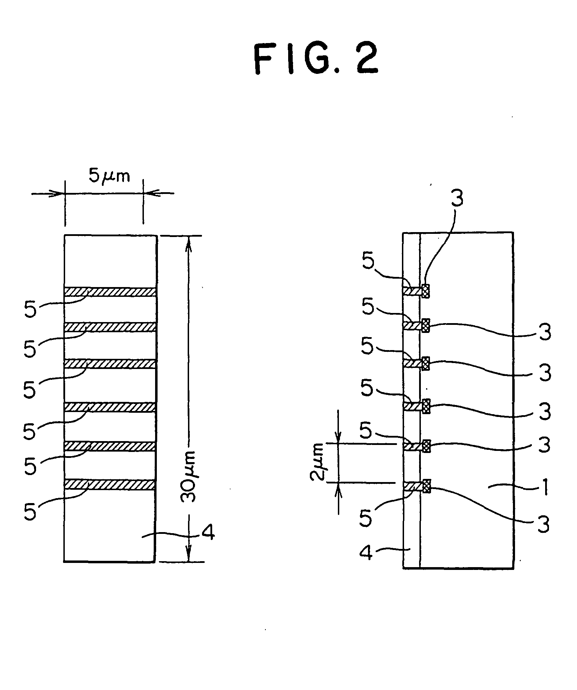

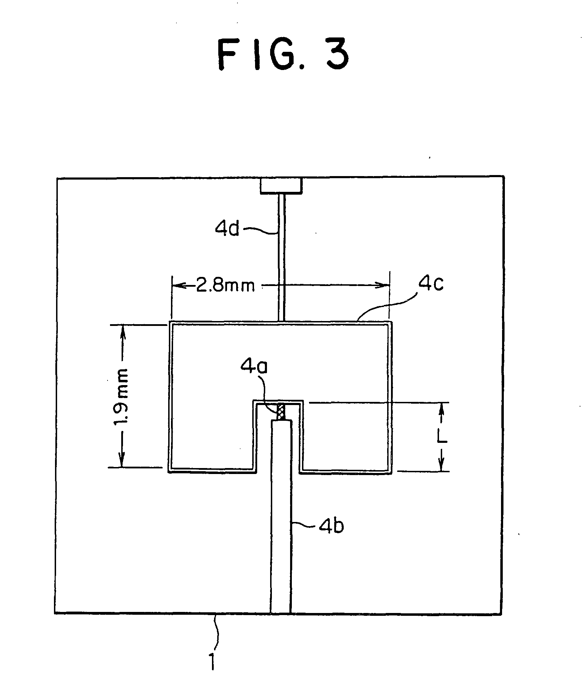

Subsequently, as shown in Fig. 2, the YBCO film 4 is patterned across the Ga irradiated region 3 to form a wiring pattern of 5 µm in width and 30 µm in length. The 30 µm length of wiring pattern serves as non-linear element 4a (in the following also called non-linear response portion) (see Fig. 3). One end of the non-linear response portion 4a is connected to an oxide superconductor thin film feed line wiring pattern (hereinafter simply referred to as "feed line wiring pattern") 4b and the other end is connected to a patch type antenna 4c.

The detail of the non-linear response portion 4a of the wiring pattern in the dimension of the 5 µm in width and 30 µm in length is shown in Fig. 2.

Fig. 2 shows the plan view and sectional side elevation of the non-linear response portion in the case where six Ga⁺ ion beams of 50 nm beam diameter are irradiated with respective intervals of 2 µm therebetween.

Fig. 3 shows one example of one unit of the preferred embodiment of the array antenna fabricated through the foregoing process. In Fig. 3, while the dimension of the patch type antenna 4c is determined depending upon the dielectric constant of the substrate 1 and resonance frequency of the substrate, in the shown embodiment, where MgO substrate 1 having 0.5 mm of thickness and 9.7 of the dielectric constant, and when the resonance frequency is 23 GHz, the preferred dimension of the patch is 1.9 mm x 2.8 mm. At the center of the patch type antenna 4, an impedance becomes substantially zero, and at the center of the lower edge when the patch is in rectangular configuration without cut-out, the impedance becomes several kΩ.

In the shown embodiment, the patch type antenna 4c is also formed of YBCO oxide superconductor film. A thin bias line 4d is provided at the side opposite to the portion where the patch antenna 4c is connected to the non-linear response portion 4a for biasing a direct current to the non-linear response portion. It should be noted that Au thin film 2 is formed in the thickness of 3 µm on the entire surface of the back side of the substrate 1.

The impedance of the non-linear response portion 4a set forth above with respect to the shown embodiment is in the order of near zero Ω to several hundreds Ω and the non-linear response portion can be realized by appropriately setting the value of L.

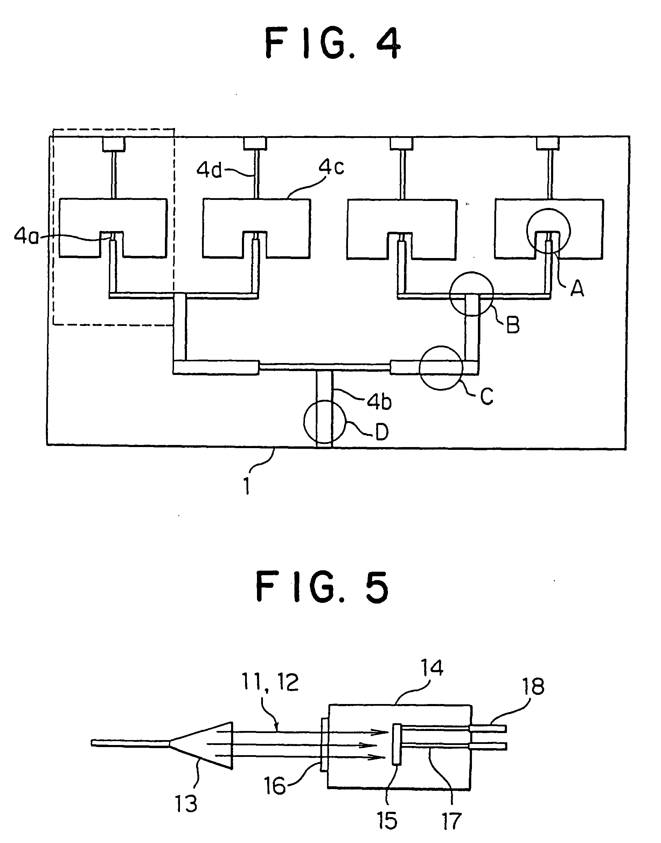

Fig. 4 shows an example of the array antenna in which four units of patch type antenna 4c are arranged. In order to establish external connection with normal 50Ω system, the impedance at the portion D of the feed line wiring pattern 4b is designed to be 50Ω. However, at the summing junction B where two signals are supplied, the feed line wiring pattern is branched to two patch type antennas 4c. Therefore, in view of impedance matching, the impedance of the antenna side is set at 100Ω and the other side (side near the portion D) is set at 50Ω. In the shown embodiment, the feed line wiring pattern providing the impedance of 100Ω has a width of approximately 80 µm, and the feed line wiring pattern providing the impedance of 50Ω has a width of approximately 500 µm.

The reason why the non-linear response portion 4a is provided at the portion A will be discussed with reference to Fig. 4. When the non-linear response portion 4a is provided at the portion B, the high frequency signal received by the patch type antenna 4c must pass the high impedance (100Ω) feed line wiring pattern of approximately 80 µm width from the portion A to the portion B. In such case, the high frequency signal should be transformed into lower frequency signal at the portion A and then transferred to the portion B to pass through the non-linear response portion. This causes greater resistance loss than in the case where the non-linear response portion is provided in the portion A. On the other hand, when the non-linear response portion 4a is provided in the portion C or D, there would arise a problem specific to the non-linear response portion, in addition to the problem caused by greater resistance loss at the high frequency than that of the low frequency. That is, the non-linear response efficiency can be lowered at quite small high frequency power. Namely, in comparison with the portion A, approximately twice greater power is concentrated at the portion C and four times greater power is concentrated at the portion D. This means that the non-linear response portion 4a becomes more sensitive to the power received at the patch type antenna for higher power level at the portions C and D and thus possibly lower the non-linear response efficiency at lower level of high frequency signal received by the patch type antenna. In the shown embodiment, since each of the non-linear response portions 4a is incorporated in each of the corresponding patch type antennas 4c, greater high frequency power can be received by the antenna.

On the other hand, as shown in Fig. 4, (direct current bias lines 4d are provided to be extracted out of the substrate from respective patch type antennas 4c, each of which direct current bias line provide the direct current bias independently of the other. With this construction, the transformation efficiency and phase variation of the non-linear response portion 4a can be independently controlled by the direct current bias. Therefore, a function, such as that for a phase controlled antenna and so forth, can be easily provided.

In order to bias the current for the non-linear response portion 4a of Figs. 3 and 4, current is supplied from the direct current bias line 4d and the feed line 4b. As a method for supplying LO signal, there is a supply method to supply the LO signal from the patch type antenna 4 or the feed line wiring pattern 4b. A method for supplying LO signal from the patch type antenna 4c is illustrated in Fig. 5.

Fig. 5 schematically shows a construction of one embodiment of a measuring equipment for evaluating the characteristics of a frequency mixing array antenna. In Fig. 5, 23 GHz RF signal 11 and 22 GHz LO (local oscillation) signal 12 are transmitted from single horn antenna 13 and irradiated on a frequency mixing array antenna 15 placed within a refrigerator 14. A quartz window 16 is provided in the refrigerator 14 so that the RF signal 11 and the LO signal 12 can be irradiated on the frequency mixing array antenna 15 even when the antenna is placed in the vacuum heat isolated space. A difference frequency between the RF signal 11 and the LO signal is called as an intermediate frequency (IF), and is 1 GHz in the shown case. Passing through the feed line of the frequency mixing array antenna 15, the IF signal 17 is output to the outside of the refrigerator 14. In addition, in order to provide direct current bias for the non-linear response portion of the frequency mixing antenna, a current terminal 18 is also provided.

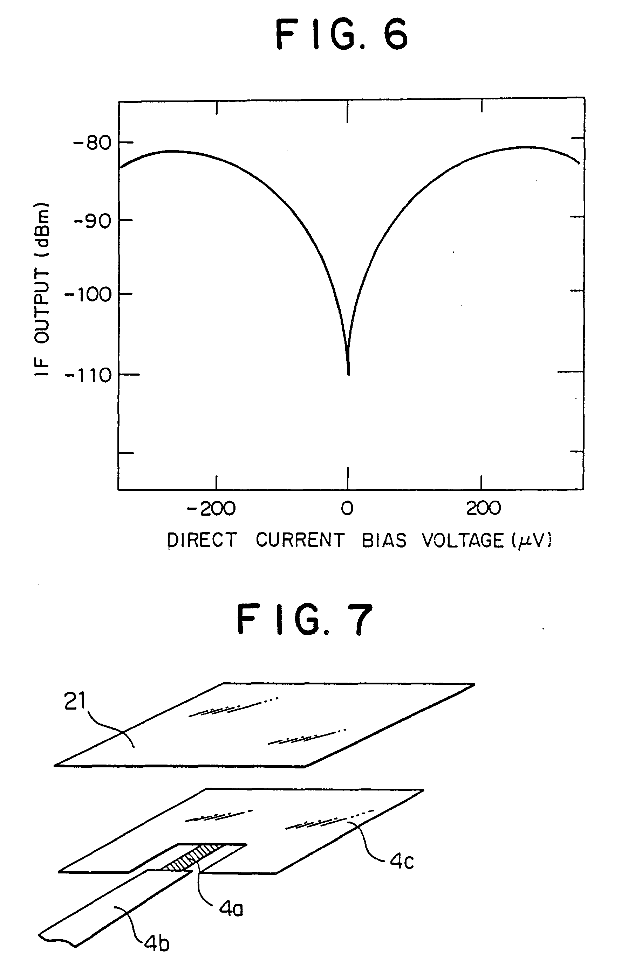

Fig. 6 shows an example, in which one patch type antenna 4c shown in Fig. 3 is measured by the measuring equipment of Fig. 5. A distance between the horn antenna 13 and the frequency mixing array antenna was approximately 10 cm. The temperature of the superconductor non-linear response portion 4a was approximately 33 °K. By the output of the horn antenna, IF signal output of -80 dBm was obtained at RF signal 11 of -40 dBm and the LO signal 12 at -30 dBm. In Fig. 6, the vertical axis represents the IF signal output and the horizontal axis represents the bias voltage applied to the non-linear response portion 4a. Even when greater than or equal to -20 dBm of power is provided for RF signal 11 and the LO signal 12 with taking the output power of the horn antenna greater than or equal to -20 dBm for both of the RF signal 11 and the LO signal 12, increasing of the IF signal was not observed.

As in the example set forth above, in general, the superconductor non-linear response portion has a characteristic to cause lowering of performance at the power higher than or equal to the RF power not to cause increasing of the IF signal despite of increasing of the RF signal. As a result, the prior art which provides the superconductor non-linear response portion 4a at the portion C or D of Fig. 4, have lower performance than that of the present invention in view point of the range of RF power to be handled.

Placement of the non-linear response portion 4a at the portion A (see Fig. 4) in the vicinity of the patch type antenna at high frequency range, which cannot be achieved in the prior art, has been achieved by novel fabrication process according to the present invention.

Conventionally, the non-linear response portion is formed by GaAs semiconductor element and so forth and requires functional connection of the semiconductor element in hybrid manner. Connection at the precision in the order of micron is not practically positioned for the array antenna for high frequency, requiring high package density. Even in the monolithic structure, in which the non-linear response portion is formed simultaneously with the feed line, it has been technically not possible in fabrication to packaging the micron size semiconductor non-linear response element which is operated at the frequency of several tens GHz in a form of array. Therefore, in the prior art, the portions C and D (see Fig. 4) or further downstream portion where power is further concentrated, at which lesser number of non-linear response portions in comparison with number of the patch type antenna are required and relatively wide area for installation can be provided.

As set forth above, according to the preferred embodiment of the fabrication process of the array antenna as discussed with respect to the process illustrated in Figs. 1A to 1D, the non-linear response portion 4a can be provided at the portion A (Fig. 4) in the vicinity of the patch type antenna 4c. The fabrication process according to the present invention, which can easily form six SNS junctions in a dimension of 5 µm x 30 µm, for example. In the fabrication process according to the present invention, by employing focused ion beam, the monolithic structure of antenna and the feed line can be formed at high precision both in size and position in further smaller area. This definitely contributes for further increasing of the package density.

With the array antenna according to the present invention, the electromagnetic wave signal input from the antenna side is transformed into lower frequency across the non-linear response portion, and the lowered frequency of the electromagnetic wave signal is transferred through the oxide superconductor film feed line wiring pattern. Therefore, the impedance matching can be established between the antenna portion and the non-linear response portion without requiring special impedance circuit so as to permit use of substantially low loss range. Therefore, the superconductor antenna can be used for higher frequency electromagnetic wave.

Also, since respective individual element of the array antenna may suppress phase of amplitude of the signal, further delicate multi-functioning can be achieved.

It should be noted that while MgO is employed as crystal substrate in the embodiment set forth above, the material for forming the substrate should not be limited to MgO but can be SrTiO₃, NdGaO₃, LaAlO₃, LaGaO₃ and so forth, and further the mixture crystal thereof. Also, while the YBCO film is formed on the substrate 1 to form the patch type antenna and the feed line on the common plane with taking the YBCO film as signal transmission line, it should be obvious to form the antenna portion as laminated structure of the superconductor and normal conductor or as solely the normal conductor.

If it is possible to reduce the high frequency power per each individual antenna by packaging the high density fine antenna at higher package density, it should be obvious to those skilled in the art to place the non-linear response portion at slightly distanced position on the feed line within a range where the impedance matching can be established.

While the embodiment where the patch type antenna and the feed line are formed on the common plane has been discussed above, it is possible that the major part of the array antenna is constructed as illustrated in Fig. 7. The construction illustrated in Fig. 7 is also obvious application of the present invention as far as lowering of the high frequency power is achieved and the position of the non-linear response portion 4a is determined in view of establishment of the impedance matching between the patch type antenna and the non-linear response portion. Namely, in the construction of Fig. 7, a second pattern 21 consisted of the superconductor or normal conductor is provided covering the portion of the patch type antenna pattern 4c. The second pattern 21 is coupled with the antenna 4c in electromagnetic field coupling so that the second pattern 21 may serve as the antenna. Then, the antenna pattern 4c may serve as a part of the feed line. Seeing the non-linear response portion in the lower layer to the second pattern 21 is a high frequency response circuit, the second pattern 21, the antenna pattern 4c regarded as a part of the lower layer feed line, and the non-linear response portion 4a form the structure according to the present invention. Namely, the construction shown in Fig. 7 can be said as the structure, in which the pattern having stronger electromagnetic field coupling is added for the structure of the present invention.

As set forth above, according to the present invention, the superconductor film wiring pattern is formed on the common plane to the reference major plane, and the non-linear response element is provided in the wiring pattern so that the antenna pattern for discharging and absorbing high frequency electromagnetic field is connected to one end thereof and the signal transmission path pattern is connected to the other end to form one unit. By connecting a plurality of units through a plurality of signal transmission patterns, the high frequency electromagnetic wave signal input from the antenna side can be transformed into lower frequency electromagnetic wave across the non-linear response portion so that the lower frequency of the electromagnetic wave is transferred through the oxide superconductor film feed line and whereby impedance matching between the antenna portion and the non-linear response portion can be established without requiring special impedance circuit. Therefore, the superconductor can be used at the frequency range where the resistance loss in transmission therethrough is substantially small. With the construction set forth above, the array antenna is permitted to handle greater power of high frequency signal to enable employment of the superconductor antenna for high frequency electromagnetic wave.

Also, since the phase and amplitude of the signal can be controlled by respective of components of the array antenna, delicate multi-functioning can be achieved.

Also, according the fabrication process of the non-linear response portion according to the present invention, the antenna pattern and the current introduction terminal pattern can be formed by depositing a protection layer in the region where the non-linear element or the non-linear element group is formed, forming the irradiated regions by irradiating the focused ion beam on the substrate, depositing the oxide superconductor on the substrate, forming the non-linear element by the modified region and the non-modified superconductor regions at both sides of the modified region, one of which forms the signal transmission line and the metal layer is formed on the oxide superconductor film wiring pattern of the other end non-modified superconductor to form the antenna pattern and the current introduction terminal pattern by patterning the metal layer. Therefore, the array antenna which is formed by high density packaging of high density fine antennas for reducing the high frequency power per each individual antenna, can be easily fabricated. Also, the fabrication process according to the present invention further contributes for high density packaging.

## Claims

1. An antenna array comprising
a substrate (1),
a plurality of unit wiring patterns, each being consisted of a superconductor film (4) formed on a common plane to a major plane of said substrate and
a plurality of antenna patterns (4c) for radiating and absorbing high frequency electromagnetic field, each of said unit wiring patterns being connected to a signal detection means through a plurality of signal transmission path patterns characterized by a non-linear element (4a) formed within each of said unit wiring patterns, said non-linear element (4a) being connected to an antenna pattern at one end and to a signal transmission path pattern (4b) at the other end.

2. An antenna array as set forth in claim 1, **characterized** in that one terminal of said non-linear element (4a) is connected to a portion of said antenna pattern (4c) having an impedance close to the impedance of said non-linear element.

3. An antenna array as set forth in claim 1, **characterized** in that said non-linear element comprises a group of non-linear regions (3) connected in series.

4. An antenna array as set forth in claim 1, **characterized** in that a current introduction terminal (4d) is provided in said unit wiring pattern and said non-linear element (4a) serves as a frequency transforming means.

5. An antenna array as set forth in claim 1, **characterized** in that said superconductor film wiring pattern is formed of oxide superconductor consisted of YBaCuO compound.

6. A process for the fabrication of a superconductor mixing antenna array comprising a non-linear superconductor element comprising the steps of:
depositing a protection layer (2) on a substrate (1) in the region where the non-linear element (4a) is to be formed;
focusing an ion beam on selected areas (3) of the protected substrate where the non-linear element (4a) is to be formed;
removing the protection layer (2);
depositing a superconductor oxide film on both the irradiated and non-irradiated regions of the substate (1) to form modified superconductor film regions (5) and un-modified superconductor regions (4), respectively;
patterning an area encompassing the modified superconductor film region to form the non-linear element (4a); and
patterning the un-modified superconductor regions to form antenna patches and a feed network.

## Patentansprüche

1. Antennenanordnung mit
einem Substrat (1),
einer Anzahl von Einheitsverdrahtungsmustern, von denen jedes aus einem supraleitenden Film (4) besteht, der auf einer gemeinsamen Ebene zu einer Hauptebene des Substrats ausgebildet ist, und
einer Anzahl von Antennenmustern (4c) zum Abstrahlen und Absorbieren eines hochfrequenten elektromagnetischen Feldes, wobei jedes der Einheitsverdrahtungsmuster mit einem Signaldetektormittel über eine Anzahl von Signalübermittlungswegmustern verbunden ist, **gekennzeichnet** durch ein nichtlineares Element (4a), das innerhalb jedes der Einheitsverdrahtungsmuster ausgebildet ist, wobei das nichtlineare Element (4a) mit einem Antennenmuster an einem Ende und mit einem Signalübermittlungswegmuster (4b) am anderen Ende verbunden ist.

2. Antennenanordnung nach Anspruch 1, dadurch **gekennzeichnet,** daß ein Anschluß des nichtlinearen Elementes (4a) mit einem Teil des Antennenmusters (4c) verbunden ist, das eine Impedanz nahe der Impedanz des nichtlinearen Elementes aufweist.

3. Antennenanordnung nach Anspruch 1, dadurch **gekennzeichnet,** daß das nichtlineare Element eine Gruppe von nichtlinearen Bereichen (3) aufweist, die in Reihe geschaltet sind.

4. Antennenanordnung nach Anspruch 1, dadurch **gekennzeichnet,** daß ein Stromeinbringanschluß (4d) in dem Einheitsverdrahtungsmuster vorgesehen ist und das nichtlineare Element (4a) als Frequenzumwandlungsmittel dient.

5. Antennenanordnung nach Anspruch 1, dadurch **gekennzeichnet,** daß das Verdrahtungsmuster aus supraleitendem Film aus Oxidsupraleiter ausgebildet ist, der aus einer YBaCuO-Verbindung besteht.

6. Verfahren zur Herstellung einer supraleitenden Mischantennenanordnung mit einem nichtlinearen supraleitenden Element mit den Schritten:
Abscheiden einer Schutzschicht (2) auf einem Substrat (1) in dem Bereich, in dem das nichtlineare Element (4a) auszubilden ist,
Fokussieren eines Ionenstrahls auf ausgewählten Flächen
(3) des geschützten Substrats, in denen das nichtlineare Element (4a) auszubilden ist,
Entfernen der Schutzschicht (2),
Abscheiden eines supraleitenden Oxidfilms auf sowohl den bestrahlten als auf den nicht bestrahlten Bereichen des Substrats (1) zur Ausbildung modifizierter supraleitender Filmbereiche (5) bzw. unmodifizierter supraleitender Bereiche (4),
Strukturieren einer Fläche, die die modifizierten supraleitenden Filmbereiche umgibt, zur Ausbildung des nichtlinearen Elementes (4a), und
Strukturieren der unmodifizierten supraleitenden Bereiche zur Ausbildung von Antennenflecken und eines Zufuhrnetzwerks.

## Revendications

1. Réseau d'antennes comprenant :
un substrat (1),
une pluralité de configurations de câblage d'unité, chacune étant constituée d'un film supraconducteur (4) formé sur un plan commun à un plan principal dudit substrat, et
une pluralité de configurations d'antennes (4c) pour rayonner et absorber un champ électromagnétique de haute fréquence, chacune desdites configurations de câblage d'unité étant connectée à un moyen de détection de signal par l'intermédiaire d'une pluralité de configurations de trajets de transmission de signaux, caractérisé par un élément non-linéaire (4a) formé à l'intérieur de chacune desdites configurations de câblage d'unité, ledit élément non-linéaire (4a) étant connecté à une configuration d'antenne à une extrémité et à une configuration de trajet de transmission de signal (4b) à l'autre extrémité.

2. Réseau d'antennes selon la revendication 1,
caractérisé en ce qu'une borne dudit élément non-linéaire (4a) est connectée à une partie de ladite configuration d'antenne (4c) dont l'impédance est proche de l'impédance dudit élément non-linéaire.

3. Réseau d'antennes selon la revendication 1,
caractérisé en ce que ledit élément non-linéaire comprend un groupe de régions non-linéaires (3) connectées en série.

4. Réseau d'antennes selon la revendication 1,
caractérisé en ce qu'une borne d'introduction de courant (4d) est prévue dans ladite configuration de câblage d'unité et ledit élément non-linéaire (4a) sert de moyen de transformation de fréquence.

5. Réseau d'antennes selon la revendication 1,
caractérisé en ce que ladite configuration de câblage de film supraconducteur est formée d'un oxyde supraconducteur consistant en un composé YBaCuO.

6. Procédé de fabrication d'un réseau d'antennes de mélange supraconducteur comprenant un élément supraconducteur non-linéaire, comprenant les étapes consistant à :
déposer une couche de protection (2) sur un substrat (1) dans la région où l'élément non-linéaire (4a) doit être formé ;
focaliser un faisceau ionique sur des zones sélectionnées (3) du substrat protégé où l'élément non-linéaire (4a) doit être formé ;
retirer la couche de protection (2) ;
déposer un film d'oxyde supraconducteur à la fois sur les régions irradiées et non irradiées du substrat (1) afin de former, respectivement, des régions de film supraconducteur modifiées (5) et des régions supraconductrices non modifiées (4) ;
configurer une zone comprenant la région de film supraconducteur modifiée afin de former l'élément non-linéaire (4a) ; et
configurer les régions supraconductrices non modifiées afin de former des pièces d'antenne et un réseau d'alimentation.
